# EUROPÄISCHE PATENTSCHRIFT

(11) **EP 1 312 142 B1**
(45) Veröffentlichungstag und Bekanntmachung des Hinweises auf die Patenterteilung: **19.04.2006**
(21) Anmeldenummer: 01969235.9
(22) Anmeldetag: 14.08.2001
(51) Int. Cl.: H01S 5/042, H03K 17/51, G01S 7/48

(54) **LASERMODUL MIT ANSTEUERSCHALTUNG**
LASER MODULE COMPRISING A DRIVE CIRCUIT
MODULE LASER AVEC CIRCUIT DE DECLENCHEMENT

(30) Priorität: 22.08.2000 DE 10041079
(43) Veröffentlichungstag der Anmeldung: 21.05.2003
(73) Patentinhaber: Osram Opto Semiconductors GmbH, 93049 Regensburg (DE)
(72) Erfinder: FERSTL, Christian, 93073 Neutraubling (DE)
(74) Vertreter: Epping - Hermann - Fischer
(86) Internationale Anmeldenummer: PCT/DE2001/003108
(87) Internationale Veröffentlichungsnummer: WO 2002/017451

(56) Entgegenhaltungen:
- DE-A- 19 524 635
- DE-A- 19 912 992
- DE-C- 19 943 127
- GB-A- 2 080 877
- JP-A- 2 125 687
- JP-A- 8 011 436
- JP-A- 11 008 415
- US-A- 3 628 048
- US-A- 3 648 073
- US-A- 4 818 099
- US-A- 5 057 906
- US-A- 5 406 572
- US-A- 5 422 900
- US-A- 5 590 144
- PATENT ABSTRACTS OF JAPAN vol. 005, no. 078 (E-058), 22. Mai 1981 (1981-05-22) -& JP 56 024991 A (TECH RES & DEV INST OF JAPAN DEF AGENCY), 10. März 1981 (1981-03-10)
- PATENT ABSTRACTS OF JAPAN vol. 005, no. 078 (E-058), 22. Mai 1981 (1981-05-22) -& JP 56 024990 A (TECH RES & DEV INST OF JAPAN DEF AGENCY), 10. März 1981 (1981-03-10)
- PATENT ABSTRACTS OF JAPAN vol. 017, no. 262 (P-1541), 24. Mai 1993 (1993-05-24) -& JP 05 002364 A (OMRON CORP), 8. Januar 1993 (1993-01-08)
- MUELLER J ET AL: "Q-SWITCHED BOW-TIE LASERS AT 1.5 MUM DRIVEN BY AN OVERSHOOT- COMPENSATED AVALANCHE PULSE GENERATOR" INTERNATIONAL JOURNAL OF OPTOELECTRONICS (INCL.OPTICAL COMPUTING & PROCESSING), TAYLOR & FRANCIS, LONDON, GB, Bd. 10, Nr. 1, 1995, Seiten 35-38, XP000582636 ISSN: 0952-5432

## Beschreibung

Die Erfindung bezieht sich auf ein Lasermödul mit einer Ansteuerschaltung nach dem Oberbegriff des Patentanspruchs 1.

Ein Lasermodul mit Ansteuerschaltung ist beispielsweise aus US 5,422,900 bekannt. Hierin ist ein Lasermodul gezeigt, das in einem Gehäuse eine Laserdiode und eine Leiterplatte enthält. Auf der Leiterplatte ist eine Ansteuerschaltung für die Laserdiode in Form einer integrierten Schaltung aufgebracht. Das beschriebene Lasermodul dient zur Erzeugung von ns-Laserimpulsen.

Leistungshalbleiterlaser mit hoher Ausgangsleistung erfordern im Betrieb hohe Stromstärken, die typischerweise im Ampere-Bereich liegen. Eine direkte Ansteuerung mit einer integrierten Schaltung, wie sie in US 5, 422,900 gezeigt ist, ist daher in der Regel nicht möglich.

Weiterhin ist bei der Erzeugung von ns-Laserimpulsen mit Leistungslaserdioden eine aufwendige Stromversorgung nötig. Diese Stromversorgung muß in der Lage sein, innerhalb der Schaltzeit, also weniger Nanosekunden, den erforderlichen Betriebsstrom in die Laserdiode einzuprägen.

Zudem erfordert die Erzeugung von ns-Laserimpulsen kurze Leitungslängen und damit eine räumlich eng benachbarte Anordnung von Stromquelle und Laserdiode. Kurze Leitungslängen sind nötig, um eine Verlängerung der Laserimpulse aufgrund von Signallaufzeiten zu vermeiden.

Aufgabe der Erfindung ist es, ein Lasermodul zu schaffen, das zur Erzeugung von ns-Laserimpulsen hoher Intensität geeignet ist. Insbesondere soll das Lasermodul mit einer technisch einfachen Stromquelle betrieben werden können.

Diese Aufgabe wird durch ein Lasermodul nach Patentanspruch 1 gelöst. Vorteilhafte Weiterbildungen der Erfindung sind Gegenstand der abhängigen Ansprüche.

Erfindungsgemäß ist vorgesehen, das Lasermodul mit einem Halbleiterlaser und einer Ansteuerschaltung zu bilden, wobei die Ansteuerschaltung einen Energiespeicher und einen elektronischen Schalter beinhaltet und der Energiespeicher mit dem Halbleiterlaser über den elektronischen Schalter verbunden ist.

Das Lasermodul ist mit einer Gehäuseformasse vergossen oder umspritzt.

Unter einem Halbleiterlaser ist dabei eine Einheit zu verstehen, die mindestens eine Laserdiode enthält. Dabei kann der Halbleiterlaser einen einzelnen Halbleiterkörper einer Laserdiode, eine Mehrzahl solcher, miteinander verschalteter Halbleiterkörper oder eine oder mehrere Laserdioden als Bauelement beinhalten.

Der oder die Halbleiterkörper können eine einzelne aktive Schicht oder eine Mehrzahl aktiver Schichten, beispielsweise in Form eines Stapels oder eines Barrens aufweisen. Weitergehend können der oder die Halbleiterkörper aus einer Mehrzahl miteinander zu einem Stapel oder Barren verbundener Einzelhalbleiterkörper gebildet sein.

Der Energiespeicher stellt eine Einheit zur Speicherung elektrischer Energie dar. Dabei wird die elektrische Energie vorzugsweise in einem elektrischen Feld nach Art eines Kondensators gespeichert. Andere Formen der gespeicherten Energie sind ebenfalls möglich, beispielsweise in Form von chemischer Energie bei einem Energiespeicher nach Art eines Akkumulators.

Der Halbleiterlaser wird bei geschlossenem elektronischem Schalter aus dem Energiespeicher mit Betriebsstrom versorgt. Wird der elektronische Schalter mit elektrischen Impulsen getaktet, so emittiert der Halbleiterlaser Laserimpulse mit einer Impulsdauer, die im wesentlichen mit der Dauer der Taktimpulse übereinstimmt.

Da Energiespeicher und Halbleiterlaser bei der Erfindung in einem Modul zusammengefaßt sind, ist eine eng benachbarte Anordnung und eine elektrische Verbindung mit kurzen Leitungslängen gewährleistet.

Mit Vorteil wird so die Signallaufzeit gering gehalten. Eine Erzeugung von ns-Laserimpulsen ist durch Ansteuerung des elektronischen Schalters mit ns-Taktimpulsen leicht möglich. Unter ns-Laserimpulsen sind insbesondere Impulse mit eine Impulsdauer unter 100 ns, vorzugsweise unter 20 ns zu verstehen.

Ein weiterer Vorteil der Erfindung besteht darin, daß aufgrund des in dem Lasermodul enthaltenen Energiespeichers die Anforderungen an eine externe Stromversorgung gesenkt sind.

Bei der Erzeugung von ns-Laserimpulsen wird der Energiespeicher nur kurzzeitig belastet, so daß ein Kondensator oder eine auf einem oder mehreren Kondensatoren basierende Schaltung als Energiespeicher zur Versorgung des Halbleiterlasers ausreicht. Dies ermöglicht eine kostengünstige und kompakte Bauweise des Lasermoduls.

Bevorzugt weist das Lasermodul einen Versorgungsanschluß auf, über den der Energiespeicher mit Energie versorgt wird. Damit wird der durch den Halbleiterlaser verursachte Verbrauch der gespeicherten Energie kompensiert, so daß mit Vorteil ein stationärer beziehungsweise quasistationärer Betrieb des Lasermoduls möglich ist.

Besonders bevorzugt ist eine direkte Verbindung zwischen Energiespeicher und Versorgungsanschluß. Ist im Betrieb der Versorgungsanschluß mit einer externen Stromquelle verbunden, so wird der Energiespeicher kontinuierlich nachgeladen.

Vorteilhafterweise wird bei einer kontinuierlichen Nachladung des Energiespeichers die externe Stromquelle nur mit der Durchschnittseingangsleistung des Lasermoduls belastet, während der Energiespeicher den zeitkritischen Spitzenleistungsbedarf während der Schaltzeiten deckt, in denen der Halbleiterlaser in Betrieb ist.

Von besonderem Vorteil ist diese kontinuierliche Versorgung bei einem geringen Tastverhältnis des erzeugten Laserimpulszugs. In diesem Fall wird die externe Stromquelle dem Tastverhältnis entsprechend nur mit einer geringen Dauerleistung belastet.

Vorzugsweise weist die Erfindung einen aus dem Lasermodul herausgeführten Steueranschluß auf, mit dem der elektronische Schalter gesteuert wird. Dies ermögliche eine flexible und direkte Steuerung der emittierten Laserimpulse.

Alternativ kann die in dem Lasermodul enthaltene Ansteuerschaltung um einen Taktgeber erweitert werden, der den elektronischen Schalter steuert. Mit Vorteil benötigt das so gebildete Lasermodul keine weitere Ansteuerung für den gepulsten Betrieb.

Bei einer vorteilhaften Weiterbildung der Erfindung ist der elektronische Schalter zweistufig ausgeführt. Dabei stellt die zweite Stufe (Schaltstufe) den eigentlichen Schalter dar, die erste Stufe (Eingangsstufe) dient als Treiber für die zweite Stufe.

Die Zweiteilung des Schalters besitzt den Vorteil, daß die zweite Stufe für das Schalten einer Hochstromlast, wie sie ein Halbleiterlaser hoher Ausgangsleistung darstellt, optimiert ist. Davon weitgehend unabhängig ist die Eingangscharakteristik des elektronischen Schalters durch die Eingangsstufe festgelegt.

Weiterhin ermöglicht diese Zweiteilung den Einsatz kommerziell erhältlicher Schalter und Treiber in der Schalt- beziehungsweise Eingangsstufe.

Bevorzugt wird als Schaltstufe ein Leistungs-MOSFET verwendet. Leistungs-MOSFETs eignen sich besonders zum Schalten hoher Ströme, so daß damit ein zuverlässig schaltendes Lasermodul realisiert werden kann.

Weiterhin wird mit Vorteil als Eingangsstufe ein MOSFET-Treiber mit hochohmigem Eingang und entsprechend geringer Leistungsaufnahme am Eingang verwendet. Solche Treiber sind ebenfalls kommerziell, beispielsweise in Form einer integrierten Schaltung, erhältlich, so daß auf diese Weise mit geringem Aufwand ein Lasermodul geschaffen werden kann, das nahezu leistungslos angesteuert werden kann.

Besonders vorteilhaft ist es hierbei, eine Eingangsstufe mit TTL-Eingang zu verwenden. Hierunter ist auch ein Eingang mit einem erweiterten Eingangsspannungsbereich zu verstehen, der mit einem TTL-Signal angesteuert werden kann. Ein so gebildetes Lasermodul kann direkt an bestehende Schaltungen mit TTL-Ausgang angeschlossen werden und erfordert weder einen gesonderten Treiber in der bestehenden Schaltung noch eine besondere Regelung der Versorgungsspannung. Weitergehend kann die Eingangsstufe mit Vorteil auch an die Signalpegel anderer Logikfamilien angepaßt sein.

Bei einer bevorzugten Ausgestaltung der Erfindung sind Halbleiterlaser, elektronischer Schalter und Energiespeicher auf einen gemeinsamen Träger montiert und über Leiterbahnen, die auf dem Träger aufgebracht sind, verbunden.

Ein so gebildetes Lasermodul zeichnet sich durch hohe Kompaktheit und besonders kurze Verbindungen zwischen den einzelnen Komponenten aus. Aufgrund der damit verbundenen geringen Signallaufzeiten eignet sich ein solches Modul besonders zur Erzeugung von Laserimpulsen mit einer Dauer von wenigen Nanosekunden.
Weiterhin können bekannte Techniken zur Herstellung von Träger, Leiterbahnen und Montage der einzelnen Komponenten verwendet werden. Dies erlaubt mit Vorteil eine kostengünstige Herstellung des Lasermoduls.

Bevorzugt wird die Erfindung zur Erzeugung von ns-Laserimpulsen hoher Spitzenleistung verwendet.
Damit eignet sich die Erfindung beispielsweise als Geber in optischen Entfernungsmeßgeräten.

Aufgrund der geringen Leistungsaufnahme, den geringen Anforderungen an die Stromversorgung und der einfachen und nahezu leistungslosen Ansteuerung bietet sich der Einsatz der Erfindung besonders in mobilen Systemen, speziell im KFZ-Bereich und im Flugzeugbau an.

Weitere Merkmale, Vorteile und Zweckmäßigkeiten der Erfindung ergeben sich aus der nachfolgenden Beschreibung von drei Ausführungsbeispielen in Verbindung mit den Figuren 1 bis 4.

Es zeigen
- Figur 1: ein Blockschaltbild eines ersten Ausführungsbeispiels eines erfindungsgemäßen Lasermoduls,
- Figur 2: ein Schaltbild eines zweiten Ausführungsbeispiels eines erfindungsgemäßen Lasermoduls,
- Figur 3: eine schematische Aufsicht eines dritten Ausführungsbeispiels eines erfindungsgemäßen Lasermoduls und
- Figur 4: die optische Leistung in Abhängigkeit der Zeit eines charakteristischen, von einem erfindungsgemäßen Lasermodul erzeugten Laserimpulses.

Gleiche oder gleichwirkende Teile sind dabei mit denselben Bezugszeichen versehen.

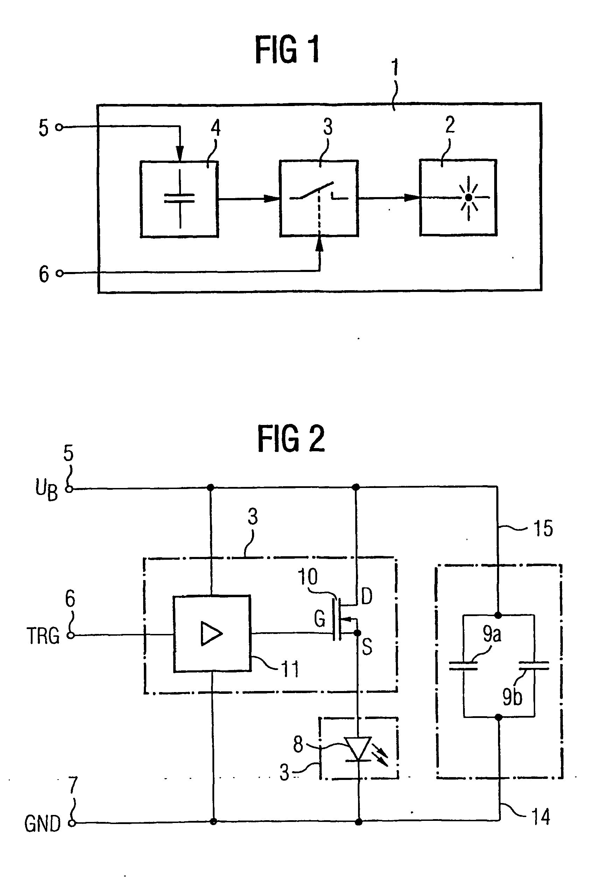

Figur 1 zeigt ein Blockschaltbild eines ersten Ausführungsbeispiels. Das Lasermodul 1 beinhaltet einen Halbleiterlaser 2, einen elektronischen Schalter 3 und einen Energiespeicher 4.

Als Halbleiterlaser 2 eignen sich insbesondere Leistungslaserdioden auf GaAs-Basis. Die Vorzüge der Erfindung, speziell die geringe Leistungsaufnahme werden besonders mit Laserdioden erreicht, die für einen Impulsbetrieb im Nanosekundenbereich ausgelegt sind. Mit solchen Laserdioden wird aufgrund der kurzen Impulsdauer eine hohe Spitzenintensität erzielt. Die Leistungsaufnahme des Lasermoduls kann dabei durch Ansteuerung mit einem kleinen Tastverhältnis gering gehalten werden kann.

Zur Stromversorgung des Halbleiterlasers 2 dient der Energiespeicher 4, der über den elektronischen Schalter 3 mit dem Halbleiterlaser verbunden ist.

Der Energiespeicher 4 weist einen externen Anschluß 5 auf, über den der Energiespeicher 4 aufgeladen wird. Mit geringem Aufwand läßt sich der Energiespeicher 4 mit einem Kondensator oder einer Mehrzahl parallel geschalteter Kondensatoren realisieren. Je nach Anwendungsfall können auch Energiespeicher mit höherer Kapazität, beispielsweise Akkumulatoren verwendet werden. Weiterhin kann der Energiespeicher mehrstufig gebildet sein, um beispielsweise den Spitzenleistungsbedarf des Halbleiterlasers gesondert zu decken.

Der den Energiespeicher 4 mit dem Halbleiterlaser 2 verbindende elektronische Schalter 3 wird über den Steueranschluß 6 angesteuert. Im geschlossenen Zustand des elektronischen Schalters 3 ist der Halbleiterlaser 2 mit dem Energiespeicher 4 verbunden, so daß sich der Energiespeicher 4 über den Halbleiterlaser 2 entlädt.

Als Schaltstufe des elektronischen Schalters 3 werden bevorzugt Leistungs-MOSFETs verwendet, die für Hochstromlasten, wie sie Halbleiterlaser hoher Ausgangsleistung darstellen, aufgrund ihrer thermischen Eigenschaften besonders geeignet sind.

Bei einer hochfrequenten Ansteuerung eines solchen MOSFETs steigt allerdings der Steuerstrom aufgrund der schnellen Umladung der MOSFET-Gatekapazität. Daher ist es vorteilhaft, die MOSFET-Schaltstufe über einen geeigneten Treiber anzusteuern, so daß die elektrischen Eigenschaften des Steuereingangs 6 von der MOSFET-Schaltstufe weitgehend unabhängig sind.

Speziell kann so der MOSFET-Schaltstufe ein hochohmiger Eingang vorgeschaltet werden, der auch im hochfrequenten Bereich eine nahezu strom- bzw. leistungslose Ansteuerung erlaubt.

In Figur 2 ist das Schaltbild eines zweiten Ausführungsbeispiels gezeigt. Als Halbleiterlaser 3 wird eine GaAs-Laserdiode 8 mit einer InAlGaAs/GaAs-QW-Struktur verwendet. Die Laserdiode besitzt eine Spitzenleistung von etwa 20 W und eine Emissionswellenlänge von 905 nm.

Als Energiespeicher 4 dient eine Parallelschaltung zweier Kondensatoren 9a und 9b. Der eine Anschluß 14 der Kondensatorparallelschaltung ist wie die Kathode der Laserdiode 8 mit dem Bezugspotentialanschluß 7, der andere Anschluß 15 mit dem Versorgungsspannungsanschluß 5 verbunden.
Über den Versorgungsspannungsanschluß 5 wird die Kondensatorparallelschaltung kontinuierlich nachgeladen beziehungsweise auf dem Potential der Versorgungsspannung gehalten.

Weiterhin steht dieser Anschluß 15 über den Leistungs-MOSFET 10 mit dem Anodenanschluß der Laserdiode 8 in Verbindung, wobei der Drainanschluß des MOSFETs 10 mit dem Anschluß 15 der Kondensatorparallelschaltung und der Sourceanschluß mit der Anode der Laserdiode 8 verbunden ist. Das Gate des MOSFETs wird mit dem Steueranschluß 6 über den MOSFET-Treiber 11 angesteuert. Als MOSFET-Treiber 11 wird ein Hochgeschwindigkeits-CMOS-Treiber mit TTL-Eingang verwendet.

Damit kann das Lasermodul nahezu strom- bzw. leistungslos mit einem TTL-Signal gesteuert werden. Das Lasermodul kann daher vorteilhafterweise ohne zusätzlichen Aufwand in bestehende TTL-Schaltungen integriert werden.

Als Hochgeschwindigkeitstreiber besonders geeignet sind MOSFET-Treiber der Familie EL7104C beziehungsweise EL7114C (Elantec Inc., Datenblatt 1994) mit Schaltzeiten von wenigen Nanosekunden.

Zum Betrieb ist der MOSFET-Treiber 11 mit dem Versorgungsanschluß 5 und dem Bezugspotentialanschluß 7 verbunden. Eine Trennung der Versorgungsspannungen für den Treiber 11 und den Energiespeicher 4 wäre problemlos möglich durch einen zusätzlich herausgeführten Anschluß, falls dies beispielsweise aufgrund des verschiedenen Leistungsbedarfs oder verschiedener Betriebsspannungen für Treiber 11 und Energiespeicher 4 erwünscht ist.
Die gezeigte Ausführungsform wiederum erlaubt ein sehr kompaktes Lasermodul, das mit einer einzigen Stromquelle betrieben werden kann.

Im Betrieb schaltet bei einem aktiven Steuersignal am Steueranschluß 6 der Treiber 11 den MOSFET 10 durch. Solange der Steueranschluß aktiviert ist, werden die Kondensatoren 9a, 9b über die Laserdiode 8 entladen. Entsprechend strahlt die Laserdiode 8 einen Laserimpuls ab.

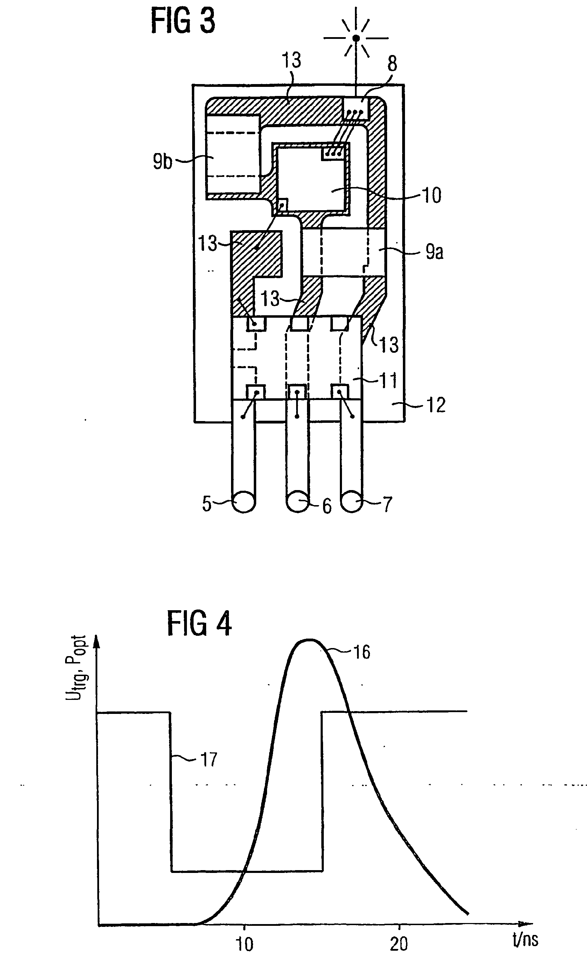

In Figur 3 ist eine Aufsicht eines weiteren Ausführungsbeispiels der Erfindung gezeigt. Die Einzelkomponenten (Laserdiode 8, Kondensatoren 9a, 9b, MOSFET 10, MOSFET-Treiber 11) sind auf einem Träger 12 montiert und über Leiterbahnen 13 sowie Drahtverbindungen gemäß dem in Figur 2 dargestellten Schaltplan verschaltet.

Die integrierte Treiberschaltung 11 und der MOSFET 10 sind auf dem Träger 12 aufgeklebt und die jeweiligen Anschlußflächen über Drahtverbindungen mit den entsprechenden Leiterbahnen 13 verbunden.

Als Kondensatoren 9a, 9b werden SMD-Kondensatoren verwendet, die direkt mit den Kontaktflächen auf die Leiterbahnen 13 gelötet sind.

Der Versorgungsanschluß 5, der Bezugpotentialanschluß 7 und der Steueranschluß 6 ist als Drahtanschluß aus dem Lasermodul 1 herausgeführt.

Zum Schutz der einzelnen Komponenten ist das gesamte Modul mit einer Gehäuseformmasse vergossen oder umspritzt. Bevorzugt wird dafür eine für die erzeugte Laserstrahlung transparente Formmasse verwendet. Alternativ kann die Emissionsfläche der Laserdiode 8 von der Formmasse freigehalten werden.

Die Abmessungen des Moduls betragen etwa 8 mm x 5 mm bei einer Dicke von etwa 3 mm. Damit steht ein sehr kompaktes, nahezu strom- bzw. leistungslos steuerbares Lasermodul mit gleichmäßig geringer Leitungsaufnahme zur Verfügung.

In Figur 4 ist ein von dem eben beschriebenen Ausführungsbeispiel emittierter, charakteristischer Laserimpuls 16 zusammen mit dem Steuerimpuls 17 dargestellt. Aufgetragen ist die optische Leistung P_{OPT} des Laserimpulses 16 sowie die Steuerspannung U_{TRG} 17 in Abhängigkeit der Zeit t.

Als Steuerimpuls 17 wird ein steilflankiger Rechteckimpuls mit einer Impulsdauer von 10 ns verwendet. Der generierte Laserimpuls 16 ist näherungsweise gaußförmig mit einer etwas verzögert abfallenden Flanke und besitzt eine typischen Impulsdauer von 6 ns (volle Halbwertsbreite). Die steigende Flanke des Laserimpulses 16 ist aufgrund der Anstiegszeit des MOSFET-Treibers 11 und des MOSFETs 10 gegen die führende Flanke des Steuerimpulses 17 um etwa 5 ns verzögert.

Die Erläuterung der Erfindung anhand der beschriebenen drei Ausführungsbeispiele ist selbstverständlich nicht als Beschränkung der Erfindung zu verstehen.

## Patentansprüche

1. Lasermodul (1) mit mindestens einem Halbleiterlaser (2) und einer Ansteuerschaltung, die einen Energiespeicher (4) und einen elektronischen Schalter (3) enthält, wobei der Halbleiterlaser (2) über den elektronischen Schalter (3) mit dem Energiespeicher (4) verbunden ist,
**dadurch gekennzeichnet, daß**
das Lasermodul mit einer Gehäuseformmasse vergossen oder umspritzt ist.

2. Lasermodul (1) nach Anspruch 1,
**dadurch gekennzeichnet, daß**
der Halbleiterlaser (2) mindestens eine Laserdiode (8) oder einen Halbleiterkörper einer Laserdiode aufweist.

3. Lasermodul (1) nach Anspruch 1 oder 2,
**dadurch gekennzeichnet, daß**
der Energiespeicher (4) mindestens einen Kondensator (9) enthält.

4. Lasermodul (1) nach einem der Ansprüche 1 bis 3,
**dadurch gekennzeichnet , daß**
das Lasermodul (1) einen Versorgungsanschluß (5) aufweist und daß der Energiespeicher (4) mit dem Versorgungsanschluß (5) verbunden ist.

5. Lasermodul (1) nach Anspruch (4),
**dadurch gekennzeichnet, daß**
der Versorgungsanschluß (5) direkt mit dem Energiespeicher (4) verbunden ist.

6. Lasermodul (1) nach einem der Ansprüche 1 bis 5,
**dadurch gekennzeichnet, daß**
das Lasermodul (1) einen Steueranschluß (6) zur Steuerung des elektronischen Schalters (3) aufweist.

7. Lasermodul (1) nach einem der Ansprüche 1 bis 6,
**dadurch gekennzeichnet, daß**
der elektronische Schalter (3) eine erste und eine zweite Stufe aufweist, wobei die zweite Stufe einen Leistungsschalter darstellt, der über die erste Stufe angesteuert wird.

8. Lasermodul (1) nach Anspruch 7,
**dadurch gekennzeichnet, daß**
die zweite Stufe ein Leistungs-MOSFET (10) ist.

9. Lasermodul (1) nach Anspruch 7 oder 8,
**dadurch gekennzeichnet, daß**
die erste Stufe eine integrierte Schaltung (11) mit hochohmigem Eingang zur Ansteuerung eines Leistungs-MOSFETs (10) ist.

10. Lasermodul (1) nach einem der Ansprüche 7, 8 oder 9,
**dadurch gekennzeichnet, daß**
die erste Stufe einen TTL-Eingang aufweist.

11. Lasermodul (1) nach einem der Ansprüche 1 bis 10, **dadurch gekennzeichnet, daß**
der Energiespeicher (4), der Halbleiterlaser (2) und der elektronische Schalter (3) auf einen gemeinsamen Träger (12) aufgebracht sind.

12. Lasermodul (1) nach Anspruch 11,
**dadurch gekennzeichnet, daß**
auf dem Träger (12) Leiterbahnen (13) ausgebildet sind, durch die der Energiespeicher (4), der Halbleiterlaser (2) und der elektronische Schalter (3) verbunden sind.

13. Verwendung eines Lasermoduls (1) nach einem der Ansprüche 1 bis 12 zur Erzeugung von Nanosekunden-Laserimpulsen mit einer Impulsdauer unter 100 ns, vorzugsweise unter 20 ns.

14. Verwendung eines Lasermoduls (1) nach einem der Ansprüche 1 bis 12 als Geber in einem optischen Abstandmesser.

## Claims

1. Laser module (1) comprising at least one semiconductor laser (2) and a drive circuit containing an energy store (4) and an electronic switch (3), the semiconductor laser (2) being connected to the energy store (4) via the electronic switch (3),
**characterized in that**
the laser module is potted or injection-moulded around with a housing moulding composition.

2. Laser module (1) according to Claim 1,
**characterized in that**
the semiconductor laser (2) has at least one laser diode (8) or a semiconductor body of a laser diode.

3. Laser module (1) according to Claim 1 or 2,
**characterized in that**
the energy store (4) contains at least one capacitor (9).

4. Laser module (1) according to one of Claims 1 to 3,
**characterized in that**
the laser module (1) has a supply terminal (5), and **in that** the energy store (4) is connected to the supply terminal (5).

5. Laser module (1) according to Claim 4,
**characterized in that**
the supply terminal (5) is directly connected to the energy store (4).

6. Laser module (1) according to one of Claims 1 to 5,
**characterized in that**
the laser module (1) has a control terminal (6) for controlling the electronic switch (3).

7. Laser module (1) according to one of Claims 1 to
6,
**characterized in that**
the electronic switch (3) has a first and a second stage, the second stage constituting a power switch that is driven via the first stage.

8. Laser module (1) according to Claim 7,
**characterized in that**
the second stage is a power MOSFET (10).

9. Laser module (1) according to Claim 7 or 8,
**characterized in that**
the first stage is an integrated circuit (11) with a high-impedance input for driving a power MOSFET (10).

10. Laser module (1) according to one of Claims 7, 8 or 9,
**characterized in that**
the first stage has a TTL input.

11. Laser module (1) according to one of Claims 1 to 10,
**characterized in that**
the energy store (4), the semiconductor laser (2) and the electronic switch (3) are applied to a common carrier (12).

12. Laser module (1) according to Claim 11,
**characterized in that**
conductor tracks (13) by means of which the energy store (4), the semiconductor laser (2) and the electronic switch (3) are connected are formed on the carrier (12).

13. Use of a laser module (1) according to one of Claims 1 to 12 for generating nanosecond laser pulses having a pulse duration of below 100 ns, preferably below 20 ns.

14. Use of a laser module (1) according to one of Claims 1 to 12 as a transmitter in an optical distance-measuring device.

## Revendications

1. Module laser (1) comprenant au moins un laser à semiconducteur (2) et un circuit de commande qui contient un accumulateur d'énergie (4) et un commutateur électronique (3), le laser à semiconducteur (2) étant relié à l'accumulateur d'énergie (4) par le biais du commutateur électronique (3), **caractérisé en ce que** le module laser est scellé ou enrobé dans une masse de moulage de boîtier.

2. Module laser (1) selon la revendication 1,
**caractérisé en ce que** le laser à semiconducteur (2) comporte au moins une diode laser (8) ou un corps semiconducteur d'une diode laser.

3. Module laser (1) selon la revendication 1 ou 2,
**caractérisé en ce que** l'accumulateur d'énergie (4) contient au moins un condensateur (9).

4. Module laser (1) selon l'une des revendications 1 à 3, **caractérisé en ce que** le module laser (1) comporte une borne d'alimentation (5) et que l'accumulateur d'énergie (4) est relié à la borne d'alimentation (5).

5. Module laser (1) selon la revendication 4,
**caractérisé en ce que** la borne d'alimentation (5) est reliée directement à l'accumulateur d'énergie (4).

6. Module laser (1) selon l'une des revendications 1 à 5, **caractérisé en ce que** le module laser (1) comporte une borne de commande (6) pour commander le commutateur électronique (3).

7. Module laser (1) selon l'une des revendications 1 à 6, **caractérisé en ce que** le commutateur électronique (3) comporte un premier et un deuxième étage, le deuxième étage comportant un commutateur de puissance qui est commandé par le biais du premier étage.

8. Module laser (1) selon la revendication 7,
**caractérisé en ce que** le deuxième étage est un MOSFET de puissance (10).

9. Module laser (1) selon la revendication 7 ou 8, **caractérisé en ce que** le premier étage est un circuit intégré (11) muni d'une entrée à haute impédance pour commander un MOSFET de puissance (10).

10. Module laser (1) selon l'une des revendications 7, 8 ou 9, **caractérisé en ce que** le premier étage comporte une entrée TTL.

11. Module laser (1) selon l'une des revendications 1 à 10, **caractérisé en ce que** l'accumulateur d'énergie (4), le laser à semiconducteur (2) et le commutateur électronique (3) sont disposés sur un support commun (12).

12. Module laser (1) selon la revendication 11, **caractérisé en ce que** sur le support (12) sont formées des pistes conductrices (13) par le biais desquelles l'accumulateur d'énergie (4), le laser à semiconducteur (2) et le commutateur électronique (3) sont reliés.

13. Utilisation d'un module laser (1) selon l'une des revendications 1 à 12 pour générer des impulsions laser au niveau des nanosecondes avec une durée d'impulsion inférieure à 100 ns, de préférence inférieure à 20 ns.

14. Utilisation d'un module laser (1) selon l'une des revendications 1 à 12 en tant que transmetteur dans un appareil de mesure de distance optique.
